# EUROPÄISCHE PATENTANMELDUNG

(11) **EP 3 474 423 A1**
(43) Veröffentlichungstag der Anmeldung: **24.04.2019**
(21) Anmeldenummer: 18199495.5
(22) Anmeldetag: 10.10.2018
(51) Int. Cl.: H02K 9/06, H02K 11/33, H02K 5/18

(54) **ANTRIEBSEINRICHTUNG FÜR EINE PUMPE**

(30) Priorität: 17.10.2017 DE 202017106269 U
(71) Anmelder: KEB Automation KG, 32683 Barntrup (DE)
(72) Erfinder: WIELE, Wolfgang, 32545 Bad Oeynhausen (DE)
(74) Vertreter: Rausch Wanischeck-Bergmann Brinkmann

(57) **Zusammenfassung**

Die Erfindung betrifft eine Antriebseinrichtung für eine Pumpe, mit einem eine Ausgangswelle (2) bereitstellenden Elektromotor (3), einem an den Elektromotor (3) angeschlossenen Frequenzumrichter (4) sowie mit einer Kühleinrichtung (5), dadurch gekennzeichnet, dass der Frequenzumrichter (4) und der Elektromotor (3) unter Zwischenordnung der Kühleinrichtung (5) in Längsrichtung (6) der Ausgangswelle (2) hintereinander und innerhalb eines gemeinsamen Gehäuses (7) angeordnet sind.

## Beschreibung

Die Erfindung betrifft eine Antriebseinrichtung für eine Pumpe, mit einem eine Ausgangswelle bereitstellenden Elektromotor, einem an den Elektromotor angeschlossenen Frequenzumrichter sowie mit einer Kühleinrichtung.

Gattungsgemäße Einrichtungen im Allgemeinen sowie solche für eine Pumpe im Speziellen sind aus dem Stand der Technik an sich gut bekannt, weshalb es eines ergänzenden druckschriftlichen Hinweises an dieser Stelle nicht bedarf.

Eine gattungsgemäße Antriebseinrichtung verfügt über einen Elektromotor. Dieser stellt eine Ausgangswelle bereit, die im bestimmungsgemäßen Verwendungsfall in Wirkverbindung mit der anzutreibenden Pumpe steht.

Gemäß der gattungsgemäßen Bauform verfügt die Antriebseinrichtung des Weiteren über einen Frequenzumrichter. Dieser ist an den Elektromotor angeschlossen und versorgt diesen im bestimmungsgemäßen Verwendungsfall mit einer in der Frequenz und Amplitude veränderbaren Wechselspannung. Es ist so gestattet, die Förderleistung der an die Antriebseinrichtung angeschlossenen Pumpe in Abhängigkeit der Drehzahl des Elektromotors einzustellen.

Die gattungsgemäße Antriebseinrichtung verfügt des Weiteren über eine Kühleinrichtung. Dabei sind typischerweise eine erste Kühleinheit für den Elektromotor und eine zweite Kühleinheit für den Frequenzumrichter vorgesehen. Diese beiden Kühleinheiten sorgen im bestimmungsgemäßen Verwendungsfall für eine Abfuhr der einerseits motorseitig und andererseits frequenzumrichterseitig entstehenden Abwärme. Eine ungewollte Überhitzung der Antriebseinrichtung wird so vermieden.

Aus der DE 103 61 748 A1 ist ein Kompaktantrieb bekannt, der einen Elektromotor und ein auf der Lüfterseite des Elektromotors axial angeordnetes Gehäuse für die Unterbringung von Elektronikbaugruppen aufweist. Dabei ist das Gehäuse mit dem Motor über ein außenliegendes Verbindungsteil verbunden und es ist vorgesehen, dass das Gehäuse mindestens an der dem Elektromotor zugewandten Stirnseite über Kühlrippen verfügt.

Aus dem Stand der Technik ist gemäß der DE 195 11 114 C1 des Weiteren ein Elektromotor bekannt, der von einem Frequenzumrichter gespeist wird und ein Kühlluftgebläse aufweist, dessen Kühlluftstrom zur Kühlung des Motors entlang von am Motorgehäuse angeordneten Längsrippen geführt ist. Der Frequenzumrichter ist seinerseits in einem separaten Gehäuse untergebracht, das lösbar mit dem Motorgehäuse verbunden ist.

Die DE 10 2014 009 313 A1 offenbart noch einen Antrieb, der ein Motorgehäuse umfasst, wobei das Motorgehäuse einen Stator zumindest in einem axialen Bereich gehäusebildend umgibt. Am Motorgehäuse ist ein Kühlkanal ausgeformt, der zumindest teilweise von einem Abdeckteil begrenzt ist.

Obgleich sich aus dem Stand der Technik vorbekannte Antriebseinrichtungen der eingangs genannten Art im alltäglichen Praxiseinsatz bewährt haben, besteht Verbesserungsbedarf, insbesondere hinsichtlich der verwenderseitigen Handhabung bei der Montage und/oder im Reparaturfall. Es ist deshalb die **Aufgabe** der Erfindung, eine gattungsgemäße Antriebseinrichtung dahingehend weiterzuentwickeln, dass eine verwenderseitige Vereinfachung in der Handhabung erreicht ist.

Zur **Lösung** dieser Aufgabe wird mit der Erfindung eine Antriebseinrichtung der eingangs genannten Art vorgeschlagen, die sich dadurch auszeichnet, dass der Frequenzumrichter und der Elektromotor unter Zwischenordnung der Kühleinrichtung in Längsrichtung der Ausgangswelle hintereinander und innerhalb eines gemeinsamen Gehäuses angeordnet sind.

Gemäß einem ersten Aspekt der erfindungsgemäßen Ausgestaltung sind der Elektromotor und der Frequenzumrichter hintereinander angeordnet, und zwar mit Bezug auf die Längserstreckung der Ausgangswelle, das heißt in Längsrichtung der Ausgangswelle. Bei aus dem Stand der Technik vorbekannten Antriebseinrichtungen sind der Elektromotor und der Frequenzumrichter durchmessererweiternd quer zur Längsrichtung der Ausgangswelle nebengeordnet. Die erfindungsgemäße Ausgestaltung erbringt somit im Unterschied zum Stand der Technik eine in Durchmesserrichtung verschlankte Bauform, so dass die erfindungsgemäße Antriebseinrichtung insgesamt kompakter ausfällt. Dies vereinfacht insbesondere die Erstmontage, da der zur Verfügung stehende Bauraum in der Regel sehr knapp bemessen ist. Auch im Reparaturfall ist ein vereinfachter Zugriff auf die einzelnen Komponenten der Antriebseinrichtung möglich, da sie dank ihrer in Längsrichtung der Ausgangswelle übereinander angeordneten Ausrichtung frei zugänglich sind. Diese freie Zugänglichkeit ist bei der Ausrichtung gemäß dem Stand der Technik nicht gegeben, da der Elektromotor und der Frequenzumrichter in Zugriffsrichtung einander nebengeordnet sind.

Gemäß einem zweiten Aspekt der erfindungsgemäßen Ausgestaltung sind der Elektromotor, der Frequenzumrichter sowie die Kühleinrichtung innerhalb eines gemeinsamen Gehäuses angeordnet. Ein solches gemeinsames Gehäuse ist nach dem Stand der Technik nicht vorgesehen. Danach stellen zumindest der Elektromotor und der Frequenzumrichter separat voneinander zu handhabende Bauteile dar, die am Verwendungsort zu montieren sind. Das nach der Erfindung vorgesehene gemeinsame Gehäuse erbringt insbesondere den Vorteil eines einfach zu handhabenden Komplettaggregats, das am Verwendungsort vormontiert bereitgestellt werden kann. Es erübrigt sich insoweit eine Einzelmontage von Elektromotor und Frequenzumrichter vor Ort, was ebenfalls einer Vereinfachung in der Handhabung insbesondere im Montagefall mit sich bringt.

Die erfindungsgemäße Hintereinanderordnung von Frequenzumrichter und Elektromotor in Längsrichtung der Ausgangswelle sowie die erfindungsgemäße Unterbringung dieser Baukomponenten innerhalb eines gemeinsamen Gehäuses erbringen in Kombination zu dem einen synergetischen Vorteil. Denn die Einhausung gestattet es, ein und dieselbe Kühleinrichtung sowohl für den Elektromotor als auch für den Frequenzumrichter zu nutzen. Dabei stellt das gemeinsame Gehäuse eine Zwangsführung für das einzubringende Kühlmedium dar, das im Betriebsfall zunächst am Frequenzumrichter und alsdann am Elektromotor vorbeiströmt. Dabei findet innerhalb des gemeinsamen Gehäuses eine Umspülung sowohl des Frequenzumrichters als auch des Elektromotors mit Kühlmedium statt, was eine effektive Kühlung bewirkt. Im Ergebnis bedarf es nur einer Kühleinrichtung sowohl für den Frequenzumrichter und den Elektromotor, die im Verhältnis zu einer nicht innerhalb eines gemeinsamen Gehäuses angeordneten Kühleinrichtung weniger leistungsstark auszulegen ist. Damit ergibt sich in Kombination der erfindungsgemäßen Merkmale der weitere Vorteil einer noch kompakteren Bauform, was ebenfalls zur vereinfachten Handhabung beiträgt.

In der einfachsten Ausgestaltung ermöglicht es die erfindungsgemäße Konstruktion, die standardmäßig von einem Elektromotor ohnehin bereitgestellte Kühleinrichtung als Kühleinrichtung der Antriebseinrichtung, das heißt als gemeinsame Kühleinrichtung für den Elektromotor einerseits und den Frequenzumrichter andererseits zu nutzen. Damit kann im Unterschied zum Stand der Technik eine separat für den Frequenzumrichter vorgesehene Kühleinheit entfallen. Insofern erweist sich die erfindungsgemäße Ausgestaltung gegenüber dem Stand der Technik zudem weniger teuer in der Herstellung.

Insgesamt erbringt die erfindungsgemäße Ausgestaltung eine im Vergleich zum Stand der Technik kompaktere Bauform, was eine verwenderseitige Handhabung vereinfacht, insbesondere im Montage- bzw. Reparaturfall. Dabei ist die erfindungsgemäße Ausgestaltung insbesondere nicht durchmessererhöhend, so dass der vor Ort zur Verfügung stehende Einbauraum besser genutzt werden kann. Die Unterbringung des Elektromotors, des Frequenzumrichters und der Kühleinrichtung in einem gemeinsamen Gehäuse erbringt zudem den Effekt, dass mit nur einer Kühleinrichtung eine gleichsame Kühlung von Elektromotor und Frequenzumrichter im bestimmungsgemäßen Verwendungsfall vorgenommen werden kann. Dabei sorgt das gemeinsame Gehäuse für eine Zwangsführung des genutzten Kühlmediums, das den Frequenzumrichter und den Elektromotor jeweils umspült.

Gemäß einem weiteren Merkmal der Erfindung ist vorgesehen, dass die Kühleinrichtung ein vom Elektromotor angetriebenes Lüfterrad aufweist. Gemäß dieser bevorzugten Ausführungsform der Erfindung wird das von einem Standard-Elektromotor ohnehin zur Verfügung gestellte Lüfterrad als Kühleinrichtung der Antriebseinrichtung genutzt.

Dabei ist gemäß einem weiteren Merkmal der Erfindung vorgesehen, dass der Elektromotor auf seiner der Ausgangswelle abgewandten Motorseite eine Lüfterradwelle bereitstellt, die das Lüfterrad trägt. Im endmontierten Zustand ergibt sich mithin in Längsrichtung der Ausgangswelle eine Anordnung, dergemäß der Elektromotor und der Frequenzumrichter hintereinander angeordnet sind, wobei sich zwischen dem Elektromotor und dem Frequenzumrichter das Lüfterrad befindet, welches entweder als zum Elektromotor separates Lüfterrad oder im einfachsten Fall als Lüfterrad des Elektromotors ausgebildet sein kann. Im Betriebsfall wird jedenfalls vom Lüfterrad angesogenes Kühlmedium, bei dem es sich um Umgebungsluft handelt, sowohl am Frequenzumrichter als auch am Elektromotor vorbeigeführt.

Gemäß einem weiteren Merkmal der Erfindung ist in diesem Zusammenhang vorgesehen, dass der Frequenzumrichter auf der Saugseite des Lüfterrads angeordnet ist. Im Betriebsfall vom Lüfterrad angesogene Umgebungsluft wird mithin zunächst am Frequenzumrichter vorbeigeführt. Die angesogene Luft gelangt alsdann auf die Druckseite des Lüfterrads und wird hier am Elektromotor vorbeigedrückt. Es entsteht mithin ein Kühlmittelfluss vom Frequenzumrichter zum Elektromotor, wobei die erfindungsgemäß vorgesehene Einhausung dafür Sorge trägt, dass die angesogene Luft zwangsgeführt an den zu kühlenden Komponenten vorbeigeleitet wird.

Das gemeinsame Gehäuse stellt gemäß einem weiteren Merkmal der Erfindung einen Luftdurchströmungsraum bereit, der frequenzumrichterseitig in eine Eingangsöffnung und elektromotorseitig in eine Ausgangsöffnung mündet. Der vom Gehäuse bereitgestellte Luftdurchströmungsraum dient dem Kühlmedium im bestimmungsgemäßen Verwendungsfall als Durchströmungskanal. Dabei sind eingangsseitig eine Eingangsöffnung für das Kühlmedium und ausgangsseitig eine Ausgangsöffnung für das Kühlmedium vorgesehen. Im bestimmungsgemäßen Verwendungsfall gelangt mithin Luft als Kühlmedium durch die Eingangsöffnung hindurch in den vom Luftdurchströmungsraum bereitgestellten Strömungskanal. Aufgrund der gehäusebedingten Zwangsführung strömt die im Luftdurchströmungsraum befindliche Luft sowohl am Frequenzumrichter als auch am Elektromotor vorbei. Infolge dessen kommt es zu einer Aufnahme der vom Frequenzumrichter einerseits und dem Elektromotor andererseits produzierten Abwärme durch die Kühlluft. Die durch die Abwärme von Frequenzumrichter und Elektromotor aufgeheizte Kühlluft verlässt den vom Gehäuse bereitgestellten Luftdurchströmungsraum sodann durch die elektromotorseitig vorgesehene Ausgangsöffnung.

Um eine möglichst effektive Abkühlung des Frequenzumrichters zu erreichen, ist dieser gemäß einem weiteren Merkmal der Erfindung mit Kühlrippen ausgerüstet. Damit ist in an sich bekannter Weise die Wärmeübertragungsfläche vergrößert, was einen gesteigerten Wärmeübergang vom Frequenzumrichter auf die den Frequenzumrichter im Betriebsfall umströmende Kühlluft erbringt.

Es ist in diesem Zusammenhang gemäß einem weiteren Merkmal der Erfindung vorgesehen, dass der Frequenzumrichter eine Gehäuseeinheit aufweist, die die Kühlrippen bereitstellt. Demnach verfügt der Frequenzumrichter über eine eigene Gehäuseeinheit, die ihrerseits die einzelnen Baukomponenten des Frequenzumrichters beherbergt. Außenseitig dieser Gehäuseeinheit sind einstückig mit der Gehäuseeinheit ausgebildete Kühlrippen vorgesehen. Dabei besteht die Gehäuseeinheit vorzugsweise aus einem gut wärmeleitenden Material, beispielsweise Aluminium. Im Inneren der Gehäuseeinheit entstehende Abwärme kann so von der Gehäuseeinheit aufgenommen und über die Kühlrippen an die die Gehäuseeinheit im Betriebsfall umströmende Kühlluft abgegeben werden.

Gemäß einem weiteren Merkmal der Erfindung ist vorgesehen, dass das Gehäuse vier zumindest in ihren geometrischen Außenabmessungen identisch ausgebildete Gehäuseseitenteile aufweist. Diese Ausgestaltung ist in mehrfacher Hinsicht von Vorteil. Zum einen wird durch die identische Ausgestaltung der Gehäuseseitenteile sichergestellt, dass es im Montagefall nicht zu einer Fehlmontage aufgrund unterschiedlicher Gehäuseseitenteile kommt. Zudem vereinfacht die Ausgestaltung identischer Gehäuseseitenteile ihre Herstellung, was unter betriebswirtschaftlichen Aspekten von Vorteil ist. Dabei können die Gehäuseseitenteile beispielsweise aus extrudiertem Aluminium hergestellt sein. Alternativ können die Gehäuseseitenteile aus Kunststoff bestehen.

Die Unterteilung des Gehäuses in Gehäuseseitenteile hat einen weiteren Vorteil. Bei der Erstmontage kann eines der Gehäuseseitenteile als Montagehilfe in Form einer Schiene genutzt werden. In einem ersten Montageschritt werden die einzelnen Baukomponenten der Antriebseinrichtung, das heißt insbesondere der Elektromotor, die Kühleinrichtung und der Frequenzumrichter auf dieser im Montagefall als Montagehilfe dienenden Gehäuseseitenwand lagesicher fixiert. Es können dann alle elektrischen, elektronischen und mechanischen Anschlüsse und Verbindungen zwischen den einzelnen Baukomponenten ausgestaltet werden. Nach Abschluss dieser Vormontage sind dann nur noch die restlichen Gehäuseseitenteile zu montieren.

Gemäß einem weiteren Merkmal der Erfindung ist vorgesehen, dass die Gehäuseseitenteile jeweils entlang ihrer Längsseiten Verbindungskonturen bereitstellen. Dabei sind die Verbindungskonturen zu den Verbindungskonturen von im endmontierten Zustand des Gehäuses benachbarten Gehäuseseitenteilen korrespondierend ausgebildet. Im endmontierten Zustand greifen mithin Verbindungskonturen benachbarter Gehäuseseitenteile ineinander. Bevorzugt ist in diesem Zusammenhang eine Nut-Federanordnung, so dass die Gehäuseseitenteile entlang ihrer zugehörigen Verbindungskonturen formschlüssig ineinandergreifen. Es ist so eine formstabile Gehäusekonstruktion vorgeschlagen, die zudem in einfacher Weise montierbar bzw. demontierbar ist.

Gemäß einem weiteren Merkmal der Erfindung verfügt das Gehäuse über Gehäusedeckel, und zwar einen ersten Gehäusedeckel elektromotorseitig sowie einen zweiten Gehäusedeckel frequenzumrichterseitig. Demnach verfügt das Gehäuse über vier Gehäuseseitenteile und zwei Deckel, wobei die Gehäusedeckel das Gehäuse jeweils stirnseitig abschließen.

Der frequenzumrichterseitig vorgesehene Gehäusedeckel weist die Eingangsöffnung für die im Betriebsfall von der Kühleinrichtung angesogene Kühlluft auf. Dementsprechend ist der elektromotorseitig vorgesehene Gehäusedeckel mit einer Ausgangsöffnung für die Kühlluft ausgerüstet.

Gemäß einer alternativen Ausgestaltung ist vorgesehen, dass die Eingangsöffnung und/oder die Ausgangsöffnung jeweils durch einen Spaltraum gebildet sind. Demgemäß ist vorgesehen, dass der frequenzumrichterseitige Gehäusedeckel zu den Gehäuseseitenteilen unter Belassung eines Spaltraums beabstandet angeordnet ist, welcher Spaltraum die Eingangsöffnung bildet. In entsprechender Weise kann der elektromotorseitige Gehäusedeckel unter Belassung eines Spaltraums beabstandet zu den Gehäuseseitenteilen angeordnet sein, welcher Spaltraum dann die Ausgangsöffnung bildet. Die Ausgestaltung entsprechender Spalträume erbringt insbesondere den Vorteil, dass aus der Umgebungsluft Kühlluft umfangsgleich verteilt angesogen bzw. ausgestoßen werden kann. Es ist so eine weitestgehend gleichmäßige Umfangskühlung gestattet.

Mit der Erfindung wird des Weiteren vorgeschlagen eine Pumpenanordnung. Die Pumpenanordnung verfügt über eine Pumpe und eine damit in Wirkverbindung stehende Antriebseinrichtung der erfindungsgemäßen Art. Eine solche Pumpenanordnung erbringt die schon vorerläuterten Vorteile.

Weitere Merkmale und Vorteile der Erfindung ergeben sich aus der nachfolgenden Beschreibung anhand der Figuren. Dabei zeigen
- Fig. 1: in schematisch perspektivischer Ansicht eine erfindungsgemäße Antriebseinrichtung;
- Fig. 2: in schematischer Seitenansicht die Antriebseinrichtung nach Fig. 1;
- Fig. 3: in teilgeschnittener Seitenansicht die erfindungsgemäße Antriebseinrichtung nach Fig. 2;
- Fig. 4: in schematischer Perspektivdarstellung das Gehäuse der erfindungsgemäßen Antriebseinrichtung;
- Fig. 5: in schematischer Draufsicht von oben das Gehäuse der erfindungsgemäßen Antriebseinrichtung nach Fig. 4;
- Fig. 6: in schematischer Draufsicht von oben die erfindungsgemäße Antriebseinrichtung nach Fig. 1;
- Fig. 7: in schematischer Draufsicht von oben den frequenzumrichterseitigen Gehäusedeckel der erfindungsgemäßen Antriebseinrichtung;
- Fig. 8: in schematischer Draufsicht von oben den elektromotorseitigen Gehäusedeckel der erfindungsgemäßen Antriebseinrichtung;
- Fig. 9: in schematischer Perspektivdarstellung die Gehäuseeinheit des Frequenzumrichters der erfindungsgemäßen Antriebseinrichtung und
- Fig. 10: in schematischer Draufsicht von vorn die Gehäuseeinheit nach Fig. 9.

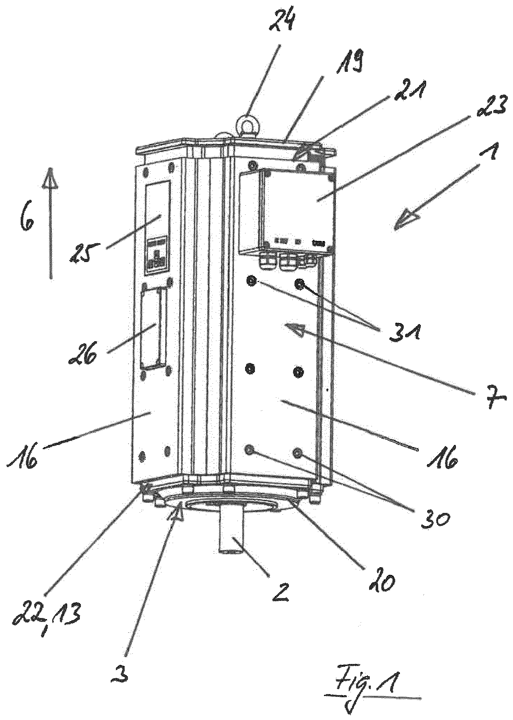

Die Figuren 1 bis 3 lassen in jeweils unterschiedlicher Ansicht die erfindungsgemäße Antriebseinrichtung 1 erkennen.

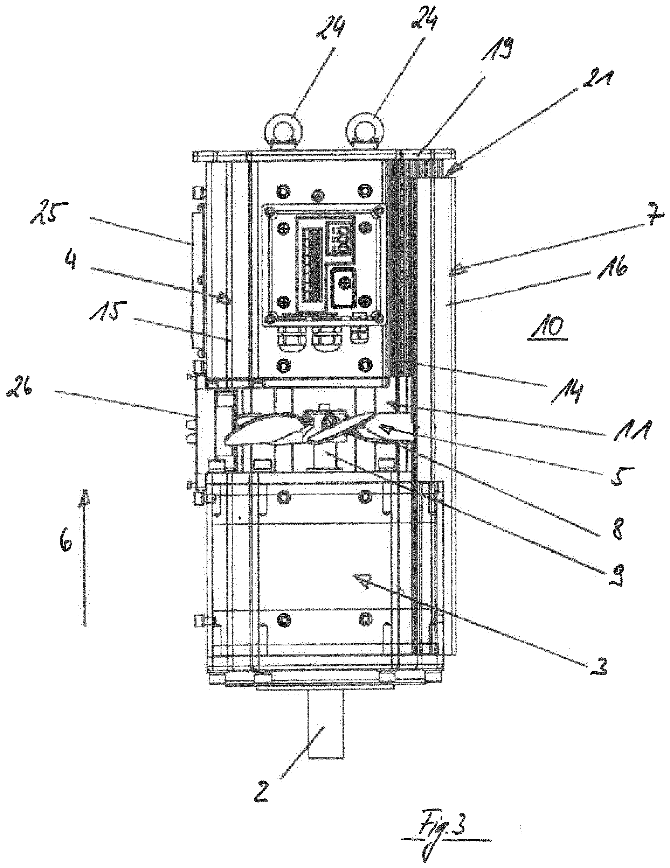

Wie insbesondere die teilgeschnittene Seitenansicht nach Fig. 3 erkennen lässt, verfügt die Antriebseinrichtung 1 über einen Elektromotor 3, einen Frequenzumrichter 4 und eine Kühleinrichtung 5. Im bestimmungsgemäßen Verwendungsfall kann die Antriebseinrichtung 1 zum Antrieb beispielsweise einer Pumpe dienen, zu welchem Zweck der Elektromotor 3 eine die Pumpe antreibende Ausgangswelle 2 bereitstellt. Erfindungsgemäß sind der Elektromotor 3 und der Frequenzumrichter 4 in Längsrichtung 6 der Ausgangswelle 2 hintereinander angeordnet, und zwar unter Zwischenordnung der Kühleinrichtung 5.

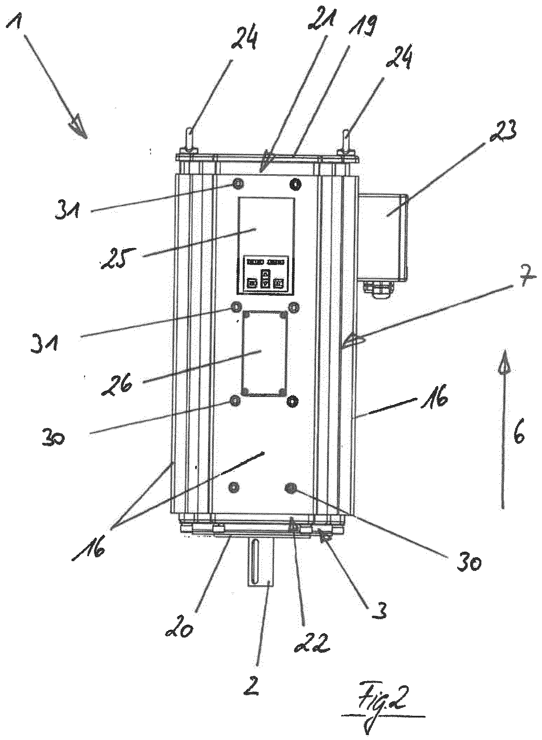

Der Elektromotor 3, der Frequenzumrichter 4 und die Kühleinrichtung 5 sind erfindungsgemäß innerhalb eines gemeinsamen Gehäuses 7 angeordnet, wie sich dies insbesondere aus der Darstellung nach den Figuren 1 und 2 ergibt. Im endmontierten Zustand befinden sich mithin der Elektromotor 3, der Frequenzumrichter 4 und die Kühleinrichtung 5 in einer gemeinsamen Einhausung.

Gemäß dem dargestellten Ausführungsbeispiel verfügt die Kühleinrichtung 5 über ein Lüfterrad 8. Dieses Lüfterrad 8 ist auf einer Lüfterradwelle 9 angeordnet, die der Elektromotor 3 auf seiner der Ausgangswelle 2 abgewandten Motorseite bereitstellt. Im bestimmungsgemäßen Betriebsfall wird vom Elektromotor 3 also nicht nur die Ausgangswelle 2, sondern auch die Lüfterradwelle 9 und damit das Lüfterrad 8 angetrieben.

Der Frequenzumrichter 4 befindet sich auf der Saugseite 10 des Lüfterrads 8. Im bestimmungsgemäßen Verwendungsfall vom Lüfterrad 8 angesogene Umgebungsluft strömt mithin zunächst über die Saugseite 10 am Frequenzumrichter 4 vorbei, bevor sie auf die Druckseite gelangt und am Elektromotor 3 vorbeigeführt wird.

Das Gehäuse 7 dient der Zwangsführung der vom Lüfterrad 8 im bestimmungsgemäßen Anwendungsfall angesogenen Kühlluft. Das Gehäuse 7 stellt zu diesem Zweck einen Luftdurchströmungsraum 11 bereit, der im Betriebsfall von Kühlluft durchströmt wird, was zu einer Luftumspülung des Frequenzumrichters 4 und des Elektromotors 3 führt. Infolge dieser Luftumspülung kommt es zu einem Abtransport der im Betriebsfall sowohl vom Frequenzumrichter 4 als auch vom Elektromotor 3 jeweils erzeugten Abwärme.

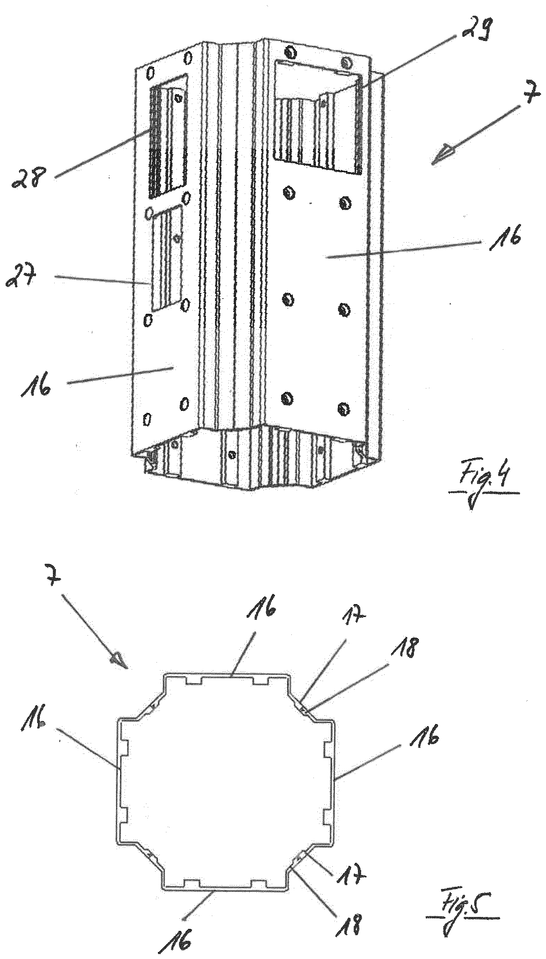

Wie sich aus einer Zusammenschau insbesondere der Figuren 4 und 5 ergibt, verfügt das Gehäuse 7 über vier Gehäuseseitenteile 16. Diese stellen jeweils Verbindungskonturen 17 und 18 bereit, wobei im endmontierten Zustand korrespondierend zueinander ausgebildete Verbindungskonturen 17 und 18 benachbarter Gehäuseseitenteile 16 ineinandergreifen. Die Gehäuseseitenteile 16 sind jeweils bevorzugterweise aus extrudierten Formteilen aus Aluminium gebildet.

Wie Fig. 4 des Weiteren erkennen lässt, verfügen die an sich identisch ausgebildeten Gehäuseseitenteile 16 über unterschiedlich ausgebildete Öffnungen 27, 28 und 29. Diese Öffnungen 27, 28 und 29 dienen jeweils dem Zugriff auf das Gehäuseinnere und/oder der Aufnahme von Anbauteilen. So dient beispielsweise die Öffnung 28 der Aufnahme einer im Betriebsfall verwenderseitig zu bedienenden Bedieneinheit 25, wie dies die Zusammenbauzeichnung nach Fig. 1 erkennen lässt. Die Öffnung 27 nimmt im endmontierten Zustand eine Abdeckung 26 auf, die im demontierten Zustand einen Zugriff auf das Lüfterrad 8 gestattet, wie sich dies aus einer Zusammenschau der Figuren 1 und 3 ergibt. Im endmontierten Zustand trägt das Gehäuse 7 ein Nebengehäuse 23, wie sich dies aus einer Zusammenschau der Figuren 1 und 2 ergibt. Dieses Nebengehäuse 23 beherbergt insbesondere Anschlusselektronik 32, wobei die elektrische bzw. elektronische Verbindung zum Elektromotor 3 bzw. dem Frequenzumrichter 4 durch die Öffnung 29 stattfindet, was sich insbesondere aus einem Vergleich der Figuren 1 und 4 ergibt.

Der Frequenzumrichter 4 und der Elektromotor 3 sind bevorzugterweise mit den Gehäuseseitenteilen 16 verschraubt, zu welchem Zweck entsprechende Schrauben 30 bezüglich des Elektromotors 3 und Schrauben 31 bezüglich des Frequenzumrichters 4 vorgesehen sind. Dabei hat die erfindungsgemäße Gehäuseausgestaltung den Vorteil, dass eine der vier Gehäuseseitenteile 16 als Montagehilfe zur Lagefixierung und Anordnung von Elektromotor 3, Frequenzumrichter 4 und Kühleinrichtung 5 dienen kann. Nach Abschluss dieser Vormontage können dann die anderen Gehäuseseitenteile 16 zur Ausbildung des Gehäuses 7 montiert werden.

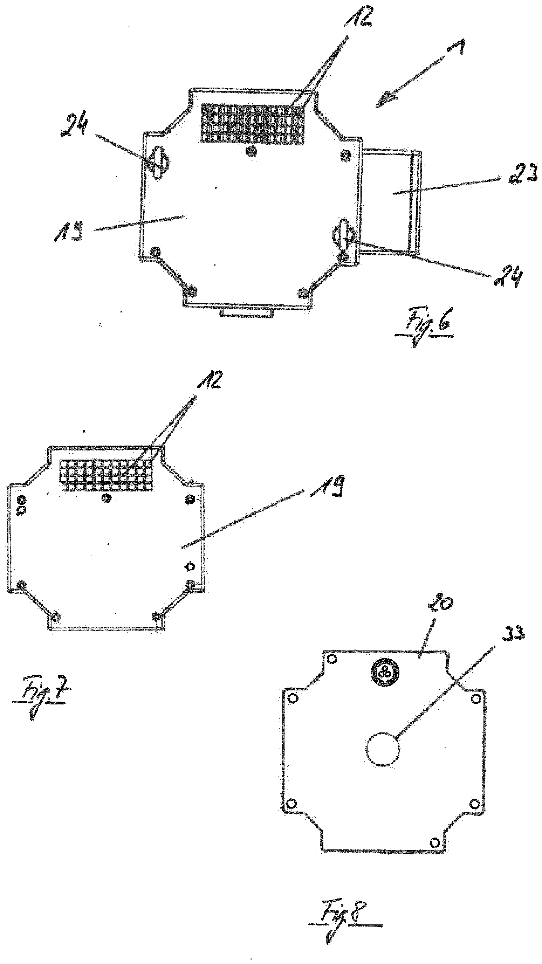

Das Gehäuse 7 ist stirnseitig mittels entsprechender Deckel verschließbar, zu welchem Zweck frequenzumrichterseitig ein Gehäusedeckel 19 und elektromotorseitig ein Gehäusedeckel 20 vorgesehen sind. Diese Gehäusedeckel sind insbesondere in den Figuren 6, 7 und 8 dargestellt.

Der frequenzumrichterseitige Gehäusedeckel 19 verfügt über Eingangsöffnungen 12, durch die hindurch Kühlluft in den vom Gehäuse 7 bereitgestellten Luftdurchströmungsraum 11 gelangen kann. In Kombination hierzu oder alternativ kann ferner vorgesehen sein, den Gehäusedeckel 19 unter Belassung eines Spaltraums 21 beabstandet zu den Gehäuseseitenteilen 16 anzuordnen, wie dies insbesondere die Darstellung nach Fig. 1 erkennen lässt. In diesem Fall dient der Spaltraum 21 als Eingangsöffnung 12.

Zum Zwecke der vereinfachten Montage ist der Gehäusedeckel 19 im Bedarfsfall mit Ösen 24 ausgerüstet, die es ermöglichen, die Antriebseinrichtung 1 im Montage- bzw. Demontagefall an eine Aufnahme eines Hebekrans oder einer hierzu vergleichbaren Einrichtung anzuhängen.

Der elektromotorseitig vorgesehene Gehäusedeckel 20 ist in Fig. 8 dargestellt. Dieser verfügt über eine Bohrung 33, durch die im bestimmungsgemäßen Verwendungsfall die Ausgangswelle 2 geführt ist, wie dies die Figuren 1 und 2 erkennen lassen. Der Gehäusedeckel 20 ist unter Belassung eines Spaltraums 22 beabstandet zu den Gehäuseseitenteilen 16 angeordnet, womit dieser Spaltraum 22 die in strömungstechnischer Verbindung mit dem Luftdurchströmungsraum 11 stehende Ausgangsöffnung 13 bildet.

Im bestimmungsgemäßen Verwendungsfall wird vom Lüfterrad 8 der Kühleinrichtung 5 von außerhalb des Gehäuses 7 Umgebungsluft als Kühlluft angesogen. Diese gelangt über die Eingangsöffnung 12 bzw. den Spaltraum 21 in den vom Gehäuse 7 bereitgestellten Luftdurchströmungsraum 11. Die innerhalb des Gehäuses 7 angeordneten Baukomponenten, das heißt insbesondere der Elektromotor 3 und der Frequenzumrichter 4 werden infolge dessen luftumspült, wobei das Gehäuse 7 eine Zwangsführung für die eingeförderte Kühlluft darstellt. Nach einem Vorbeiströmen der Kühlluft am Frequenzumrichter 4 sowie am Elektromotor 3 vorbei wird die durch Abwärme vom Frequenzumrichter 4 und Elektromotor 3 aufgewärmte Kühlluft über den als Ausgangsöffnung 13 dienenden Spaltraum 22 elektromotorseitig an die Umgebungsluft abgegeben.

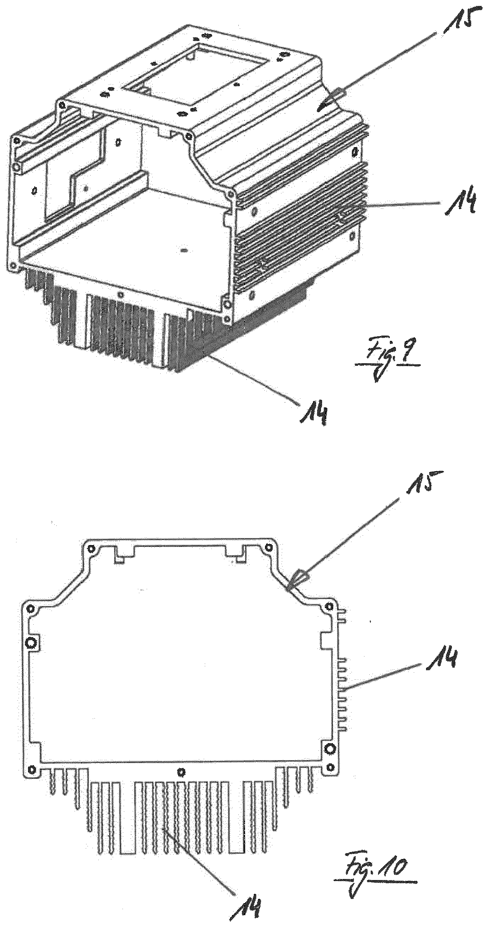

Um eine besonders effektive Kühlung des Frequenzumrichters 4 erreichen zu können, verfügt der Frequenzumrichter 4 über eine Gehäuseeinheit 15, wie sie beispielhaft in den Figuren 9 und 10 dargestellt ist. Diese Gehäuseeinheit 15 ist als einstückiges Teil vorzugsweise aus einem wärmeleitenden Material wie zum Beispiel Aluminium gebildet. Einstückig mit der Gehäuseeinheit 15 sind Kühlrippen 14 vorgesehen, die eine besonders effektive Wärmeabfuhr an die im Betriebsfall die Gehäuseeinheit 15 umspülende Kühlluft bewirken.

### Bezugszeichen

| | | | |
|---|---|---|---|
| 1 | Antriebseinrichtung | 18 | Verbindungskontur |
| 2 | Ausgangswelle | 19 | Gehäusedeckel |
| 3 | Elektromotor | 20 | Gehäusedeckel |
| 4 | Frequenzumrichter | 21 | Spaltraum |
| 5 | Kühleinrichtung | 22 | Spaltraum |
| 6 | Längsrichtung | 23 | Nebengehäuse |
| 7 | Gehäuse | 24 | Öse |
| 8 | Lüfterrad | 25 | Bedieneinheit |
| 9 | Lüfterradwelle | 26 | Abdeckung |
| 10 | Saugseite | 27 | Öffnung |
| 11 | Luftdurchströmungsraum | 28 | Öffnung |
| 12 | Eingangsöffnung | 29 | Öffnung |
| 13 | Ausgangsöffnung | 30 | Schraube |
| 14 | Kühlrippe | 31 | Schraube |
| 15 | Gehäuseeinheit | 32 | Elektronik |
| 16 | Gehäuseseitenteil | 33 | Bohrung |
| 17 | Verbindungskontur | | |

## Patentansprüche

1. Antriebseinrichtung für eine Pumpe, mit einem eine Ausgangswelle (2) bereitstellenden Elektromotor (3), einem an den Elektromotor (3) angeschlossenen Frequenzumrichter (4) sowie mit einer Kühleinrichtung (5), **dadurch gekennzeichnet, dass** der Frequenzumrichter (4) und der Elektromotor (3) unter Zwischenordnung der Kühleinrichtung (5) in Längsrichtung (6) der Ausgangswelle (2) hintereinander und innerhalb eines gemeinsamen Gehäuses (7) angeordnet sind.

2. Antriebseinrichtung nach Anspruch 1, **dadurch gekennzeichnet, dass** die Kühleinrichtung (5) ein von Elektromotor (3) angetriebenes Lüfterrad (8) aufweist.

3. Antriebseinrichtung nach Anspruch 2, **dadurch gekennzeichnet, dass** der Elektromotor (3) auf seiner der Ausgangswelle (2) abgewandten Motorseite eine Lüfterradwelle (9) bereitstellt, die das Lüfterrad (8) trägt.

4. Antriebseinrichtung nach Anspruch 2 oder 3, **dadurch gekennzeichnet, dass** der Frequenzumrichter (4) auf der Saugseite (10) des Lüfterrads (8) angeordnet ist.

5. Antriebseinrichtung nach einem der vorhergehenden Ansprüche, **dadurch gekennzeichnet, dass** das Gehäuse (7) einen Luftdurchströmungsraum (11) bereitstellt, der frequenzumrichterseitig in eine Eingangsöffnung (12) und elektromotorseitig in eine Ausgangsöffnung (13) mündet.

6. Antriebseinrichtung nach einem der vorhergehenden Ansprüche, **dadurch gekennzeichnet, dass** der Frequenzumrichter (4) mit Kühlrippen (14) ausgerüstet ist.

7. Antriebseinrichtung nach Anspruch 6, **dadurch gekennzeichnet, dass** der Frequenzumrichter (4) eine Gehäuseeinheit (15) aufweist, die die Kühlrippen (14) bereitstellt.

8. Antriebseinrichtung nach einem der vorhergehenden Ansprüche, **dadurch gekennzeichnet, dass** das Gehäuse (7) vier in ihren geometrischen Außenabmessungen identisch ausgebildete Gehäuseseitenteile (16) aufweist.

9. Antriebseinrichtung nach Anspruch 8, **dadurch gekennzeichnet, dass** die Gehäuseseitenteile (16) jeweils entlang ihrer Längsseiten Verbindungskonturen (17, 18) bereitstellen, die zu den Verbindungskonturen (17, 18) von im endmontierten Zustand des Gehäuses (7) benachbarten Gehäuseseitenteilen (16) korrespondierend ausgebildet sind.

10. Antriebseinrichtung nach einem der vorhergehenden Ansprüche, **dadurch gekennzeichnet, dass** das Gehäuse elektromotorenseitig sowie frequenzumrichterseitig jeweils einen Gehäusedeckel (19, 20) aufweist.

11. Antriebseinrichtung nach einem der vorhergehenden Ansprüche, **dadurch gekennzeichnet, dass** der frequenzumrichterseitig vorgesehene Gehäusedeckel (19) die Eingangsöffnung (12) aufweist.

12. Antriebseinrichtung nach Anspruch 10 oder 11, **dadurch gekennzeichnet, dass** der frequenzumrichterseitig vorgesehene Gehäusedeckel (19) zu den Gehäuseseitenteilen (16) unter Belassung eines Spaltraums (21) beabstandet angeordnet ist, welcher Spaltraum (21) die Eingangsöffnung (12) bildet.

13. Antriebseinrichtung nach einem der vorhergehenden Ansprüche 10, 11 oder 12, **dadurch gekennzeichnet, dass** der elektromotorseitige Gehäusedeckel (20) die Ausgangsöffnung (13) aufweist.

14. Antriebseinrichtung nach einem der vorhergehenden Ansprüche 10 bis 14, **dadurch gekennzeichnet, dass** der elektromotorseitige Gehäusedeckel (20) zu den Gehäuseseitenteilen (16) unter Belassung eines Spaltraums (22) beabstandet angeordnet ist, welcher Spaltraum (22) die Ausgangsöffnung (13) bildet.

15. Pumpenanordnung mit einer Pumpe und einer damit in Wirkverbindung stehenden Antriebseinrichtung (1) nach einem der vorhergehenden Ansprüche 1 bis 14.
